# EUROPÄISCHE PATENTANMELDUNG

(11) **EP 2 209 012 A2**
(43) Veröffentlichungstag der Anmeldung: **21.07.2010**
(21) Anmeldenummer: 09015295.0
(22) Anmeldetag: 10.12.2009
(51) Int. Cl.: G01R 11/04

(54) **Adapterbaugruppe zur Anbringung an einer Tragplatte einer Zählerplatzinstallation**

(30) Priorität: 10.12.2008 DE 102008061265; 03.09.2009 DE 102009039874
(71) Anmelder: Hager Electro GmbH & Co. KG, 66131 Saarbrücken (DE)
(72) Erfinder: Kelaiditis, Konstantin, 66386 St Ingbert (DE); Zimmermann, Michael, 66399 Mandelbachtal (DE)
(74) Vertreter: Bernhardt, Reinold

(57) **Zusammenfassung**

Die Erfindung betrifft eine Adapterbaugruppe (1) zur Anbringung an der Tragplatte (2) einer Zählerplatzinstallation, mit einem Anschlussbereich (6) für einen elektronischen Stromzähler (5), einem neben diesem Anschlussbereich (6) vorgesehenen Anschlussbereich (9) für weitere Geräte (12,13) und einer Anschlussleiste (14) für den Anschluss von Phasenleitern und des Nullleiters. Erfindungsgemäß ist die Anschlussleiste am unteren Rand in der Mitte einer nach oben über den Anschlussbereich des Stromzählers hinaus vorstehenden Grundplatte angeordnet.

## Beschreibung

### "Adapterbaugruppe zur Anbringung an einer Tragplatte einer Zählerplatzinstallation"

Die Erfindung betrifft eine Adapterbaugruppe zur Anbringung an der Tragplatte einer Zählerplatzinstallation, mit einem Anschlussbereich für einen elektronischen Stromzähler, einem neben diesem Anschlussbereich angeordneten Anschlussbereich für weitere Geräte und einer Anschlussleiste für den Anschluss von Phasenleitern und des Neutralleiters.

Eine Adapterbaugruppe solcher Art ist aus der DE 102 61 206 D4 bekannt. Die Adapterbaugruppe tritt an die Stelle eines herkömmlichen elektro-mechanischen Stromzählers und lässt sich am Zählerkreuz der Zählertragplatte befestigen. Ein Anschlussbereich für den elektronischen Stromzähler und ein Anschlussbereich für weitere Geräte sind symmetrisch zur vertikalen Mittellinie der Adapterbaugruppe vorgesehen. Die vertikale Mittellinie der Baugruppe verläuft durch die Längsmitte des Anschlussleistenkörpers.

Der Erfindung liegt die Aufgabe zugrunde, eine in Bezug auf die Raumausnutzung verbesserte Adapterbaugruppe der eingangs erwähnten Art zu schaffen.

Die diese Aufgabe lösende Adapterbaugruppe nach der Erfindung ist **dadurch gekennzeichnet, dass** die Anschlussleiste am unteren Rand in der Mitte einer nach oben über den Anschlussbereich für den elektronischen Stromzähler hinausreichenden Grundplatte vorgesehen ist.

Vorteilhaft lässt sich durch diese Erfindungslösung der auf einer Zöhlertragplatte zwischen oberem und unterem Anschlussraum verfügbare Platz besser für die Installation zusätzlicher Geräte nutzen.

Zweckmäßig handelt es sich bei der Grundplatte um eine Rechteckplatte und der Anschlussbereich für die zusätzlichen Geräte erstreckt sich über die gesamte vertikale Länge der Platte. Gegebenenfalls können auch unmittelbar oberhalb des Anschlussbereichs für den Stromzähler zusätzliche Geräte installiert werden.

In einer bevorzugten Ausführungsform der Erfindung weist die Grundplatte Öffnungen zur Befestigung der Adapterbaugruppe an einem Zählerkreuz der Zählertragplatte auf. Bei diesen Öffnungen kann es sich um Randeinschlitzungen zur Befestigung der Grundplatte am horizontalen Schenkel des Zählerkreuzes handeln. Vorzugsweise weist eine Öffnung für die Befestigung der Grundplatte am vertikalen Schenkel des Zählerkreuzes einen sich horizontal erstreckenden Abschnitt auf. Sofern die Zählertragplatte hierfür Platz bietet, lässt sich dann der Anbringungsort der Adapterbaugruppe vorteilhaft variieren, so dass der Stromzähler eine gewünschte Position einnimmt, wobei die Randeinschlitzungen eine vertikale und der horizontale Abschnitt eine horizontale Verschiebung ermöglichen.

Die Grundplatte kann in jeder Ecke mit einem Befestigungsloch versehen sein, wobei diese Löcher dann nutzbar sind, wenn auf einer Zählertragplatte kein Zählerkreuz vorhanden ist.

In einer weiteren bevorzugten Ausführungsform der Erfindung ist an der Oberseite des Anschlussbereichs für den Stromzähler eine weitere Anschlussleiste für vom Stromzähler wegführende Phasenleiter sowie den Neutralleiter vorgesehen. Diese, zusätzlich zu den Anschlüssen an der erstgenannten Leiste vorhandenen Anschlüsse lassen sich z.B. nutzen, um bequemer als über die erstgenannten Anschlüsse eine Verbindung zu einem installierten Zusatzgerät herzustellen.

Zweckmäßig stehen von der Grundplatte Haltewände und -fächer zum Halten bzw. zur Aufnahme leitender Anschlusselemente für den Stromzähler und für die Anschlussleisten vor.

In letzterer Ausführungsform weist die Adapterbaugruppe neben der Grundplatte zweckmäßig einen Deckelteil auf, der eine Abdeckplatte für den Stromzähler bildet und mit dem vorzugsweise Trägerschienen für die weiteren Geräte sowie ggf. Abdeckungen für die Anschlussleisten einstückig verbunden sind.

Die Adapterbaugruppe kann ferner eine Abdeckhaube aufweisen, welche die Grundplatte vollständig überdeckt und nach unten über die Grundplatte hinaus vorsteht, um durch eine Öffnung in der Zählertragplatte hindurchgeführte Anschlussleitungen abzudecken.

Diese Abdeckplatte kann durch mehrere, den Stromzähler in der Anschlussposition untergreifende Laschen an der Adapterbaugruppe sowie durch weitere Befestigungsmittel, wie z.B. eine Schraube, gehalten sein. Zur Lösung der Abdeckung bedürfte es dann einer Lösung der Plombierung und Entfernung des Stromzählers.

In weiterer Ausgestaltung der Erfindung sind Einrichtungen zur wahlweisen Herstellung einer der Spannungsversorgung dienenden Leitungsverbindung zwischen gezählten und ungezählten Strom führenden Leitern und wenigstens einem weiteren Gerät vorgesehen.

Die genannten Einrichtungen zur Herstellung einer Leitungsverbindung können zusätzliche Anschlussbuchsen an der genannten Anschlussleiste, an denen Versorgungsspannungen abgreifende Verbindungskabel wahlweise anschließbar sind, umfassen.

In einer besonders bevorzugten Ausführungsform weisen die Einrichtungen zur wahlweisen Herstellung der Leitungsverbindungen Verbindungskabel auf, die unter der Aufnahmeplatte für den elektrischen Stromzähler mit den genannten Leitern verbunden sind. Hierdurch lässt sich der Aufwand für die Installation von Kabeln zur Spannungsversorgung der Zusatzgeräte vermindern.

Während es denkbar ist, die genannten Verbindungskabel mit deren freien Enden unmittelbar an dem weiteren Gerät anzuschließen, sind in einer besonders bevorzugten Ausführungsform der Erfindung die Verbindungskabel lösbar oder unlösbar mit einem, vorzugsweise auf der Grundplatte angeordneten, Element zum wahlweisen Anschluss weiterer, die Leitungsverbindung komplettierender Verbindungskabel verbunden. Zur Herstellung der Leitungsverbindung wird dann zwischen diesem Anschlusselement und dem betreffenden weiteren Zusatzgerät eine Leitungsverbindung hergestellt.

Für die verschiedenen, mit einem gezählten oder ungezählten Strom führenden Leiter verbundenen Verbindungskabel kann ein einziges, wahlweise für den einen oder anderen Leiter benutzbares, Anschlusselement vorgesehen sein, das mit dem Verbindungskabel dementsprechend lösbar verbunden ist.

In einer Ausführungsform der Erfindung umfasst das Anschlusselement mehrere Anschlussplätze, vorzugsweise Steckanschlussplätze zur Verbindung mit mehreren weiteren Geräten.

In einer weiteren besonders bevorzugten Ausführungsform der Erfindung ist das Anschlusselement zur Anordnung und ggf. zur Befestigung an der Adapterbaugruppe in unterschiedlichen Positionen vorgesehen. Dies ermöglicht unterschiedliche Anordnungen von Zusatzgeräten, denen das Anschlusselement in nur einer Anordnungsposition ggf. im Wege stände.

Zweckmäßig ist das Anschlusselement in einer der Positionen unter einer Abdeckung angeordnet. Bei dieser Position handelt es sich ggf. um eine Parkposition, in der die Anschlüsse des Anschlusselements nicht genutzt werden.

In weiterer Ausgestaltung der Erfindung weist das Anschlusselement eine die elektrische Verbindung zwischen den Leitern und dem weiteren Gerät schließende Sicherung auf. Diese Sicherung kann unter Schaltung der elektrischen Verbindung, vorzugsweise an einer Halterung, in einen an dem Anschlusselement vorgesehenen Schacht einsetzbar sein.

Zweckmäßig ist das Verbindungskabel, das mit einem ungezählten Strom führenden Leiter verbunden ist, mit dem freien, der Verbindung mit dem Leiter abgewandten Ende in eine durch den plombierten Stromzähler abgedeckte Tasche in der Aufnahmeplatte einlegbar. Durch diese Maßnahme ist gesichert, dass Unbefugte keinen ungezählten Strom entnehmen können.

In weiterer Ausgestaltung der Erfindung ist ein die Grundplatte verbreiterndes Anschlussstück vorgesehen. Mit diesem Anschlussstück können Teile einer Halteeinrichtung für weitere Geräte, insbesondere Hutprofilträgerschienen, und ggf. eine die Grundplatte nach oben erweiternde Verlängerung verbunden sein.

Die Erfindung wird nachfolgend anhand eines Ausführungsbeispiels und der beiliegenden, sich auf dieses Ausführungsbeispiel beziehenden Zeichnungen näher erläutert. Es zeigen:
- Fig. 1: eine erfindungsgemäße Adapterbaugruppe mit angeschlossenem elektronischen Stromzähler in perspektivischer Ansicht,
- Fig. 2: eine Grundplatte der Adapterbaugruppe von Fig. 1,
- Fig. 3: die Adapterbaugruppe von Fig. 1 ohne Abdeckhaube,
- Fig. 4: die Adapterbaugruppe von Fig. 1 ohne Abdeckhaube mit angeschlossenen Zusatzgeräten, und
- Fig. 5: die Abdeckhaube von Fig. 1 komplett ohne angeschlossenen Stromzähler,
- Fig. 6: eine erfindungsgemäße Adapterbaugruppe mit einem Anschlusselement in einer Arbeitsposition,
- Fig. 7: eine Detaildarstellung der Adapterbaugruppe von Fig. 6 mit einem Anschlusselement in Parkstellung,
- Fig. 8: eine Detaildarstellung der Adapterbaugruppe von Fig. 6 mit einem Anschlusselement in einer weiteren Arbeitsposition,
- Fig. 9: eine Detaildarstellung der Adapterbaugruppe von Fig. 6 mit einer ein Anschlusselement in der Parkposition verschließenden Abdeckhaube,
- Fig. 10: die Adapterbaugruppe von Fig. 6 mit einer Gesamtabdeckung, und
- Fig. 11: eine Detaildarstellung der Adapterbaugruppe von Fig. 6, welche die Verdrahtung eines Kommunikationsmoduls erläutert.

Eine Adapterbaugruppe 1 ist zur Anbringung an einer Zählertragplatte 2 einer Zählerplatzinstallation mit einem oberen Anschlussraum 3 und einem unteren Anschlussraum 4 vorgesehen. Die Zählerplatzinstallation dient zur Aufnahme eines herkömmlichen elektro-mechanischen Stromzählers. Über die Adapterbaugruppe 1 kann an der Zählerplatzinstallation ein elektronischer Stromzähler 5 angeschlossen werden.

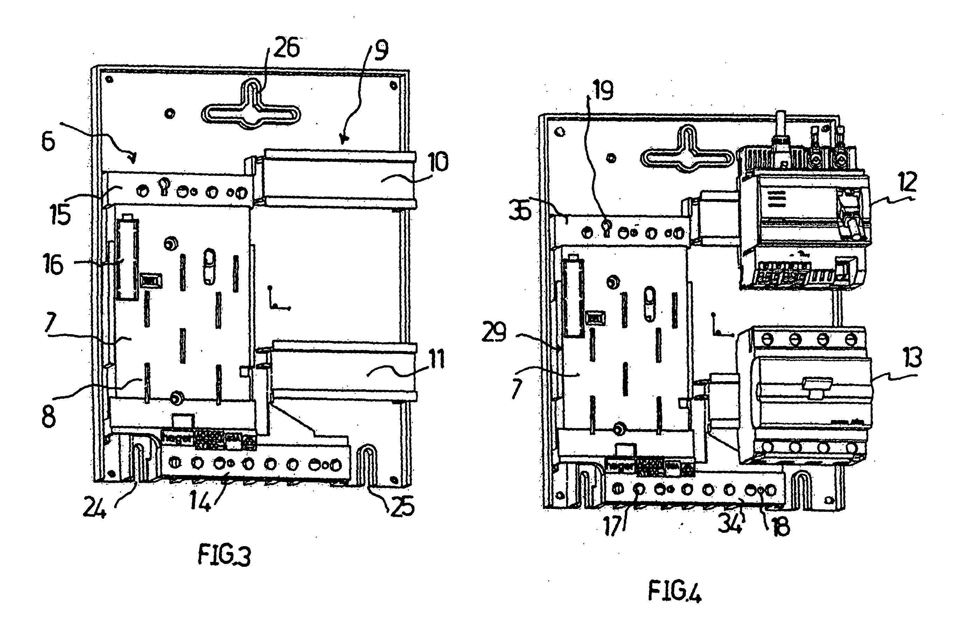

Zur Aufnahme des elektronischen Stromzählers 5 dient ein Anschlussbereich 6 mit einer Aufnahmeplatte 7, in der, wie aus den Fig. 3 und 4 hervorgeht, Durchtrittsschlitze 8 für von dem Stromzähler 5 vorstehende Anschlusskontakte gebildet sind. Durch Verschiebung auf der Aufnahmeplatte 7 in Längsrichtung der Durchtrittsschlitze 8 lässt sich der Stromzähler 5 in eine Anschlussposition bringen.

Neben dem Anschlussbereich 6 ist ein weiterer Anschlussbereich 9 für zusätzliche Geräte vorgesehen, die auf Hutprofilträgerschienen 10 und 11 montierbar sind. Fig. 4 zeigt als zusätzliche Geräte beispielhaft einen Kommunikationsmodul 12 und einen über den Kommunikationsmodul 12 ansteuerbaren Schalter 13.

Eine Anschlussleiste 14 für zum Stromzähler 5 hin und vom Stromzähler 5 wegführende Phasenleiter L1,L2,L3 sowie den Nullleiter N ist unterhalb der Anschlussbereiche 6,9 horizontal zu diesen versetzt in der Mitte der Adapterbaugruppe 1 angeordnet.

An eine weitere, oberhalb der Aufnahmeplatte 7 für den Stromzähler 5 angeordnete Anschlussleiste 15 lassen sich nur von dem Stromzähler 5 wegführende Phasenleiter L1,L2,L3 sowie der Neutralleiter N anschließen.

Die Aufnahmeplatte 7 weist ein ausbrechbares Fenster 16 für Signalleitungen auf, die an den elektronischen Stromzähler 5 und ggf. an den Kommunikationsmodul 12 anschließbar sind. Durch runde Öffnungen 17 in den Anschlussleisten 14,15 hindurch sind Schraubklemmanschlusselemente zugänglich. Weitere runde Öffnungen 18 dienen zur Einführung von Kabeln zum Abgreifen von Spannungen, z.B. zur Versorgung der Geräte 12 und 13. Bei 19 lässt sich ein den Stromzähler 5 gegen Verschiebung sicherndes Steckschloss einführen.

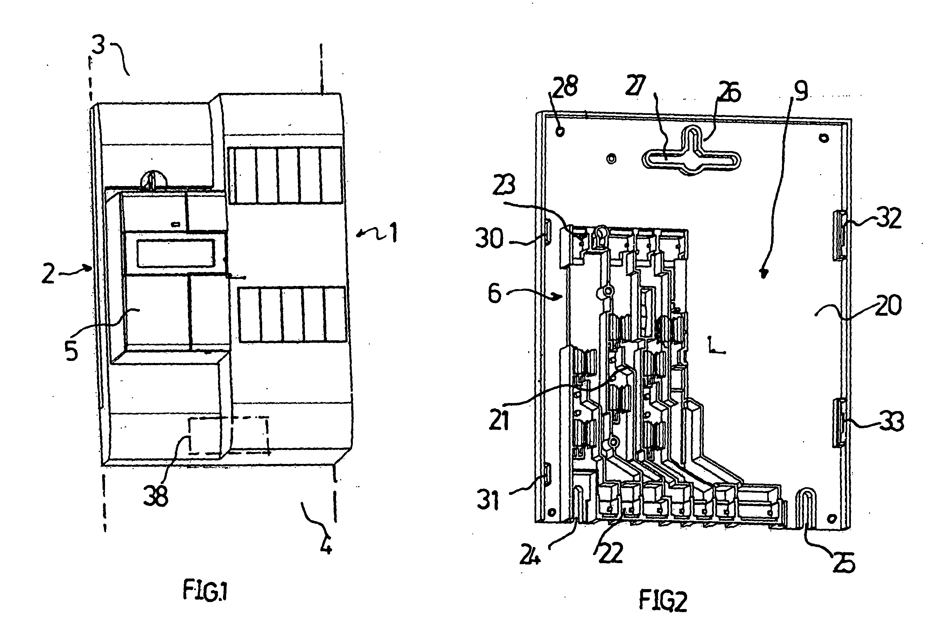

Wie Fig. 2 erkennen lässt, weist die Adapterbaugruppe 1 in dem gezeigten Ausführungsbeispiel eine Grundplatte 20 auf, von der Halterungswände und -fächer 21 zur Aufnahme von leitenden, den Stromzähler kontaktierenden Anschlusselementen vorstehen. Ferner sind vorstehende Halterungsfächer 22 und 23 für Anschlusselemente der Anschlussleisten 14 und 15 gebildet.

Die Grundplatte 20 weist ferner symmetrisch zu den Haltefächern 22 angeordnete Randeinschlitzungen 24 und 25 auf, die der Befestigung der Grundplatte 20 am horizontalen Schenkel eines an der Zählertragplatte 2 vorgesehenen Zählerkreuzes dienen. Über eine Öffnung 26 mit einem sich horizontal erstreckenden Bereich 27 lässt sich die Grundplatte 20 am vertikalen Schenkel des Zählerkreuzes befestigen. Vier Befestigungslöcher 28 an den Ecken der Grundplatte 20 kommen bei Zählertragplatten ohne Zählerkreuz zum Einsatz.

Die von der Grundplatte vorstehenden Haltewände und -fächer 21 bis 23 sind durch ein die Aufnahmeplatte 7 bildendes Deckelteil 29 abdeckbar, das u.a. bei 30,31 sowie 32,33 an der Grundplatte 20 einrastbar ist. Mit der Aufnahmeplatte 7 des Deckelteils 29 einstückig verbunden sind die Hutprofilträgerschienen 10 und 11 sowie Abdeckungen 34 und 35 für die Anschlussleisten 14 und 15.

Die Adapterbaugruppe 1 umfasst ferner eine einstückige Abdeckhaube 36 mit einer Öffnung 37 für den Durchtritt des Stromzählergehäuses. Die Abdeckhaube 36 erstreckt sich über die gesamte Fläche der Grundplatte 20 und den unteren Rand der Grundplatte 20 hinaus, so dass sie eine in der Zählertragplatte 2 gebildete Durchtrittsöffnung 38 für Anschlussleitungen abdeckt.

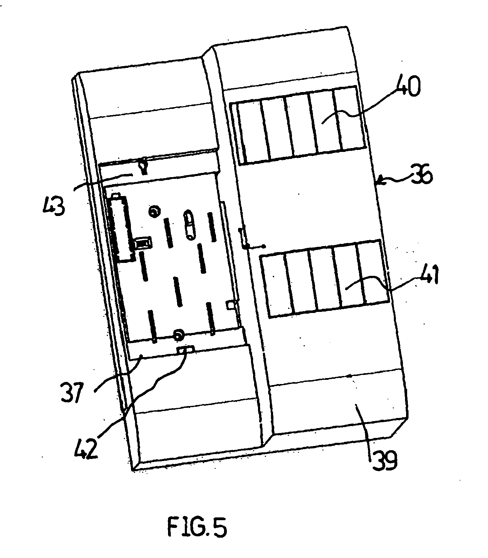

Wie die Figuren 1 und 5 erkennen lassen, ist ein den Anschlussbereich 9 abdeckender Teil 39 der Abdeckhaube 36 erhöht, und in dem erhöhten Teil 39 sind ausbrechbare Fenster 40 und 41 gebildet.

Oberhalb und unterhalb des Stromzählers weist die Abdeckhaube 36 ein Laschenteil 42 bzw. 43 auf, das den Stromzähler in seiner Anschlussposition untergreift. Die Abdeckhaube 36 ist damit durch den Stromzähler oberhalb und unterhalb des Stromzählers und ferner am Rand der Grundplatte 7 an der übrigen Adapterbaugruppe festgehalten.

Der horizontale Abschnitt 27 der Öffnung 26 erlaubt, sofern hierzu ausreichend Platz vorhanden ist, eine in gewissen Grenzen variable Anbringung der Adapterbaugruppe 1 an einer Zählertragplatte 2. Durch die zentrale Lage der Anschlussleiste 14 können vorhandene Anschlusskabel in unveränderter Position genutzt werden.

Über die Anschlussleiste 15 lassen sich von dem Stromzähler wegführende Kabel bequem mit dem Schalter 13 verbinden und die Kabel dann von dem Schalter 13 über die Anschlussleiste 14 hinweg innerhalb des erhöhten Haubenteils 39 durch die Öffnung 38 hindurch in der Zählertragplatte 2 zurückführen. Der durch das Kommunikationsgerät 12 ansteuerbare Schalter 13 lässt sich daher zur Unterbrechung der Stromversorgung durch Fernauslösung nutzen.

Die Anschlussleiste 15 lässt sich auch zur direkten Verdrahtung mit dem oberen Anschlussraum 3 nutzen. Zweckmäßig weist die Abdeckhaube 36 hierfür ausbrechbare Bereiche für die Bildung von Durchführungsöffnungen auf.

Der Zwischenraum zwischen dem betreffenden Ende der Anschlussleiste 14 und der Randeinschlitzung 25 kann vorteilhaft als Durchführungsbereich für Leitungen dienen.

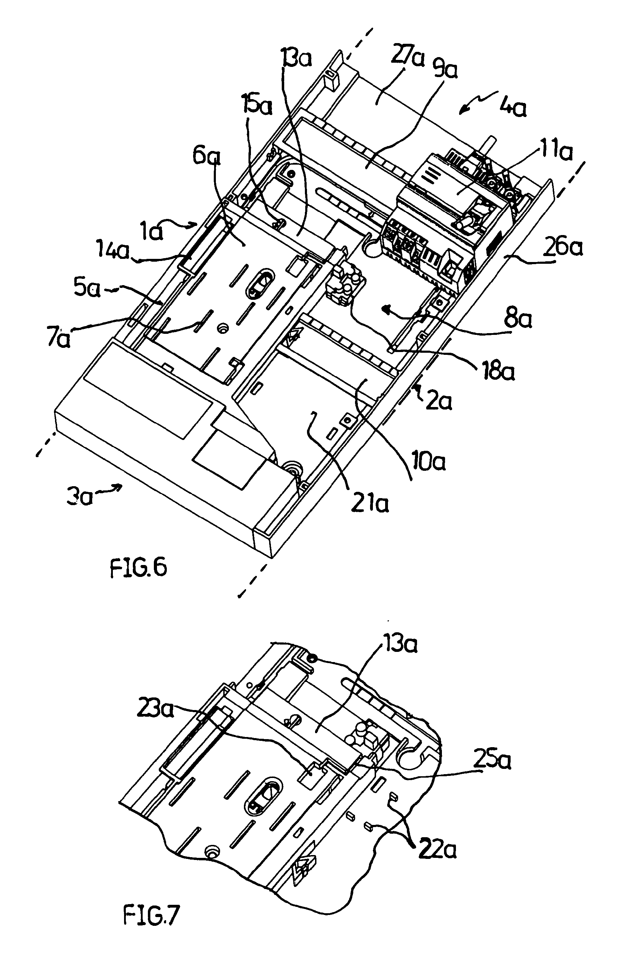

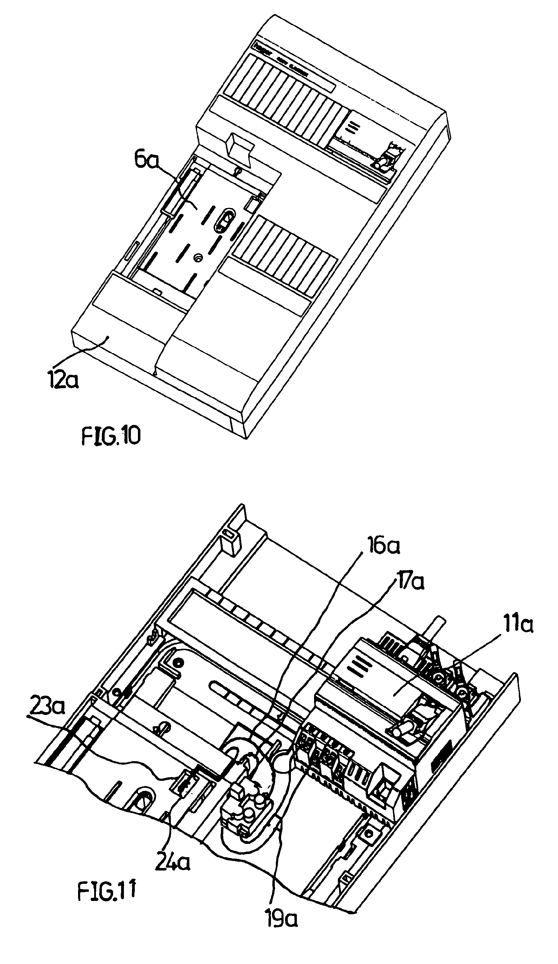

Eine in den Figuren 6 bis 11 gezeigte Adapterbaugruppe 1a, wie sie ähnlich anhand der Fig. 1 bis 6 beschrieben ist, ist zur Anbringung an einer Zählertragplatte 2a einer Zählerplatzinstallation, die einen oberen Anschlussraum 3a und einem unteren Anschlussraum 4a aufweist vorgesehen. Die Zählerplatzinstallation dient zur Aufnahme eines herkömmlichen elektro-mechanischen Stromzählers. Über die Adapterbaugruppe 1a kann an der Zählerplatzinstallation ein elektronischer Stromzähler angeschlossen werden.

Zur Aufnahme des elektronischen Stromzählers dient eine Befestigungs- und Kontaktiereinrichtung 5a mit einer Aufnahmeplatte 6a, in der Durchtrittsschlitze 7a für von dem Stromzähler vorstehende Anschlusskontakte gebildet sind. Durch Verschiebung auf der Aufnahmeplatte 6a in Längsrichtung der Durchtrittsschlitze 7a lässt sich der Stromzähler in eine Anschlussposition bringen.

Neben dem durch die Befestigungs- und Kontaktiereinrichtung 5a mit der Aufnahmeplatte 6a gebildeten Anschlussbereich für den elektronischen Stromzähler ist auf einer Grundplatte 21a ein weiterer Anschlussbereich 8a für zusätzliche Geräte vorgesehen, die auf Hutprofilträgerschienen 9a und 10a montierbar sind. Fig. 6 zeigt als zusätzliches Gerät beispielhaft einen Kommunikationsmodul 11.

Zu einer Anschlussleiste unter einer Abdeckung 12a führen zum Stromzähler hin und vom Stromzähler wegführende Phasenleiter L1,L2,L3 sowie der Neutralleiter N. Die Anschlussleiste ist horizontal versetzt zu der Befestigungs- und Kontaktiereinrichtung 5a und dem Anschlussbereich 8a in der Mitte der Adapterbaugruppe 1a an deren unterem Rand angeordnet.

An eine weitere, oberhalb der Aufnahmeplatte 6a für den Stromzähler angeordnete Anschlussleiste 13a lassen sich nur von dem Stromzähler wegführende Phasenleiter L1,L2,L3 sowie der Neutralleiter N anschließen.

Die Aufnahmeplatte 6a weist ein ausbrechbares Fenster 14a für Signalleitungen auf, die den elektronischen Stromzähler mit dem Kommunikationsmodul 11a verbinden.

Bei 15a lässt sich ein den Stromzähler gegen Verschiebung sicherndes Steckschloss in die Anschlussleiste 13a einführen.

Von der Adapterbaugruppe nach den Figuren 1 bis 6 unterscheidet sich die in den Figuren 6 bis 11 beschriebene Adapterbaugruppe durch Einrichtungen zur wahlweisen Herstellung einer elektrischen Verbindung zwischen dem Kommunikationsmodul 11a und gezählten oder ungezählten Strom führenden Leitern (nicht gezeigt), die in der Befestigungs- und Kontaktiereinrichtung 5a unter der Aufnahmeplatte 6a angeordnet sind. Die Einrichtungen umfassen mit den genannten Leitern unter der Aufnahmeplatte 6a ständig verbundene Kabel 16a und 17a, die mit einem Steckanschlusselement 18a verbunden sind. Das Kabel 16a ist mit einem Phasenleiter L und das Kabel 17a mit dem Neutralleiter N verbunden. Zwischen dem Anschlusselement 18a und dem Kommunikationsmodul 11a kann dann nach Wahl eine der Spannungsversorgung des Kommunikationsmoduls 11a dienende Leitungsverbindung 19a hergestellt werden.

Das Anschlusselement kann mehrere Anschlussplätze zur Herstellung von Verbindungen zu mehreren Zusatzgeräten aufweisen, insbesondere mehrere Steckplätze.

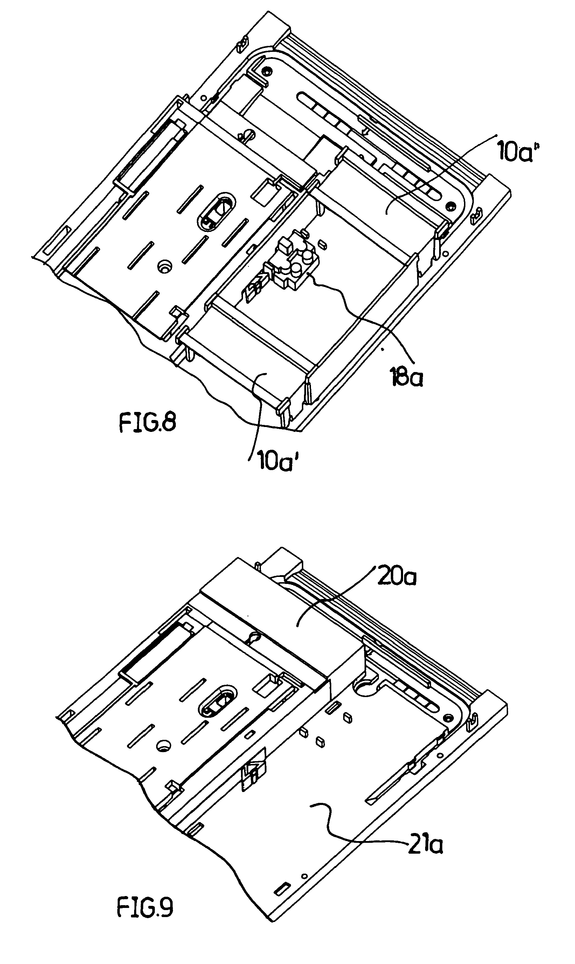

Das Anschlusselement 18a lässt sich in mehreren Positionen auf der Grundplatte 21a anordnen und befestigen. In einer Parkposition oberhalb der Befestigungs- und Kontaktiereinrichtung 5a lässt es sich durch eine Abdeckung 20a gegen ungewollte Berührung sichern. Bei Verwendung einer langen Hutprofilträgerschiene 9a oberhalb der Befestigungs- und Kontaktiereinrichtung 5a und einer kürzeren Hutprofilträgerschiene 10a neben der Befestigungs- und Kontaktiereinrichtung 5a ist das Anschlusselement 18a zur Anordnung in einer Arbeitsposition neben der Befestigungs- und Kontaktiereinrichtung 5a an deren oberem Ende vorgesehen, wie dies in Fig. 6 dargestellt ist. Bei Verwendung gleich langer, neben der Befestigungs- und Kontaktiereinrichtung 5a angeordneter Hutprofilträgerschienen 10a',10a" (Fig. 8) ist die Arbeitsposition des Anschlusselements 18a weiter nach unten versetzt. Zur Befestigung in den verschiedenen Positionen dienen von der Grundplatte 21a vorstehende Zapfen 22a.

Die Aufnahmeplatte 6a der Befestigungs- und Kontaktiereinrichtung 5a weist eine Tasche 23a auf, in der sich das freie Ende eines weiteren Anschlusskabels 24a unterbringen lässt, das an einem Ende ständig mit einem unter der Aufnahmeplatte 6a angeordneten, ungezählte Strom führenden Leitern verbunden ist. Bei angeschlossenem und plombiertem Stromzähler sind die Tasche 23a und ein Zuführungskanal 25a verschlossen und das Kabel 24a ist nicht zugänglich. Bei abgenommenem Stromzähler kann es anstelle des Kabels 16a mit dem Anschlusselement 18a verbunden werden. So lässt sich der Kommunikationsmodul durch das Stromversorgungsunternehmen mit ungezähltem Strom versorgen, während der Nutzer nur die Möglichkeit zum Betrieb mit gezähltem Strom hat.

Wie Fig. 6 erkennen lässt, ist die Grundplatte 21 a seitlich durch ein Anschlussstück 26a erweitert, das mit den Hutprofilträgerschienen 9a und 10a und ferner mit einem die Adapterbaugruppe nach oben erweiternden Verlängerung 27a verbunden ist.

Das Anschlusselement enthält eine Sicherung sowie ein Halterung 28a für die Sicherung. Die Sicherung lässt sich unter Schaltung der Leitungsverbindung in einen Schacht im Anschlusselement 18a einführen.

## Patentansprüche

1. Adapterbaugruppe (1) zur Anbringung an der Tragplatte (2) einer Zählerplatzinstallation, mit einem Anschlussbereich (6) für einen elektronischen Stromzähler (5), einem neben diesem Anschlussbereich (6) vorgesehenen Anschlussbereich (9) für weitere Geräte (12,13) und einer Anschlussleiste (14) für den Anschluss von Phasenleitern und des Neutralleiters,
**dadurch gekennzeichnet,**
**dass** die Anschlussleiste (14) am unteren Rand in der Mitte einer nach oben über den Anschlussbereich (6) für den Stromzähler (5) hinausreichenden Grundplatte (20) angeordnet ist.

2. Baugruppe nach Anspruch 1,
**dadurch gekennzeichnet,**
**dass** die Grundplatte (20) eine Rechteckplatte ist.

3. Baugruppe nach Anspruch 1 oder 2,
**dadurch gekennzeichnet,**
**dass** sich der Anschlussbereich (9) für die weiteren Geräte (12,13) über die gesamte vertikale Länge der Grundplatte (20) erstreckt.

4. Baugruppe nach einem der Ansprüche 1 bis 3,
**dadurch gekennzeichnet,**
**dass** die Grundplatte (20) Öffnungen (24-27) zur Befestigung der Baugruppe (1) an einem Zählerkreuz aufweist.

5. Baugruppe nach Anspruch 4,
**dadurch gekennzeichnet,**
**dass** Randeinschlitzungen (24,25) zur Befestigung der Grundplatte (20) am horizontalen Schenkel des Zählerkreuzes vorgesehen sind.

6. Baugruppe nach Anspruch 4 oder 5,
**dadurch gekennzeichnet,**
**dass** eine Öffnung (26) für die Befestigung der Grundplatte (20) am vertikalen Schenkel des Zählerkreuzes einen sich horizontal erstreckenden Öffnungsabschnitt (27) aufweist.

7. Baugruppe nach einem der Ansprüche 2 bis 6,
**dadurch gekennzeichnet,**
**dass** die Grundplatte (20) an jeder Ecke ein Befestigungsloch (28) aufweist.

8. Baugruppe nach einem der Ansprüche 1 bis 7,
**dadurch gekennzeichnet,**
**dass** an der Oberseite des Anschlussbereichs (6) für den Stromzähler (5) eine weitere Anschlussleiste (15) für vom Stromzähler wegführende Phasenleiter sowie den Nullleiter vorgesehen ist.

9. Baugruppe nach einem der Ansprüche 1 bis 7,
**dadurch gekennzeichnet,**
**dass** von der Grundplatte (20) Haltewände und -fächer (21-23) zum Halten leitender Anschlusselemente für den Stromzähler (5) und leitender Anschlusselemente für die Anschlussleisten (14,15) vorstehen.

10. Baugruppe nach einem der Ansprüche 1 bis 9,
**dadurch gekennzeichnet,**
**dass** die Baugruppe (1) neben der Grundplatte (20) einen Deckelteil (29) aufweist, der eine Aufnahmeplatte (7) für den Stromzähler (5) bildet und mit dem ggf. Trägerschienen (10,11) für die weiteren Geräte (12,13) oder/und Abdeckungen (34,35) für die Anschlussleisten einstückig verbunden sind.

11. Baugruppe nach einem der Ansprüche 1 bis 10,
**dadurch gekennzeichnet,**
**dass** die Baugruppe (1) eine die genannte Grundplatte (20) vollständig überdeckende und sich nach unten über die Grundplatte 20 hinaus erstreckende Abdeckhaube (36) aufweist.

12. Baugruppe nach Anspruch 11,
**dadurch gekennzeichnet,**
**dass** die Abdeckhaube (36) durch mehrere, den Stromzähler (5) untergreifende Laschen (42) an der Baugruppe (1) arretierbar.

13. Baugruppe nach einem der Ansprüche 1 bis 12,
**dadurch gekennzeichnet,**
**dass** Einrichtungen zur wahlweisen Herstellung einer der Spannungsversorgung dienenden Leitungsverbindung zwischen gezählten oder ungezählten Strom führenden Leitern und wenigstens einem weiteren Gerät (11) vorgesehen sind.

14. Baugruppe nach Anspruch 13,
**dadurch gekennzeichnet,**
**dass** die Einrichtungen zur wahlweisen Herstellung der Leitungsverbindung Verbindungskabel (16a,17a;24a) umfassen, die unter der Aufnahmeplatte (6a) für den elektronischen Stromzähler mit den genannten Leitern verbunden sind.

15. Adapterbaugruppe nach Anspruch 14,
**dadurch gekennzeichnet,**
**dass** die Verbindungskabel (16a,17a;24a) lösbar oder unlösbar mit einem, vorzugsweise auf der Grundplatte (21 a) angeordneten, Element (18a) zum wahlweisen Anschluss weiterer, die Leitungsverbindung komplettierender Verbindungskabel (19a) verbunden sind.
